# FASCICULE DE BREVET EUROPEEN

(11) **EP 2 643 919 B1**
(45) Date de publication et mention de la délivrance du brevet: **18.01.2017**
(21) Numéro de dépôt: 11794562.6
(22) Date de dépôt: 17.11.2011
(51) Int. Cl.: H02K 11/04

(54) **PROCEDE D'INTERCONNEXION DE MODULES ELECTRONIQUES DE PUISSANCE D'UNE MACHINE ELECTRIQUE TOURNANTE ET ASSEMBLAGE DE MODULES DE PUISSANCE INTERCONNECTES OBTENU PAR CE PROCEDE**
VERFAHREN ZUR VERBINDUNG VON ELEKTRONISCHEN LEISTUNGSMODULEN EINER ELEKTRISCHEN DREHMASCHINE UND ANHAND DIESES VERFAHRENS HERGESTELLTE ANORDNUNG AUS MITEINANDER VERBUNDENEN LEISTUNGSMODULEN
METHOD FOR INTERCONNECTING ELECTRONIC POWER MODULES OF A ROTARY ELECTRIC MACHINE AND ASSEMBLY OF INTERCONNECTED POWER MODULES OBTAINED USING SAID METHOD

(30) Priorité: 23.11.2010 FR 1059632
(43) Date de publication de la demande: 02.10.2013
(73) Titulaire: Valeo Equipements Electriques Moteur, 94046 Créteil Cedex (FR)
(72) Inventeur: SEIDENBINDER, Régis, F-94600 Choisy Le Roi (FR); LAFABRIE, Bryann, F-94000 Creteil (FR); TAUVRON, Fabrice, F-91200 Athis Mons (FR); DHERIPRE, Cyrille, F-62600 Berck Sur Mer (FR); DELPLACE, David, F-62176 Camiers (FR); TUNZINI, Marc, F-78000 Versailles (FR); GUILLARD, Romaric, F-91120 Palaiseau (FR); LOPEZ, Ruth, F-75005 Paris (FR); WEN, Jie, F-92130 Issy Les Moulineaux (FR)
(86) Numéro de dépôt international: PCT/FR2011/052673
(87) Numéro de publication internationale: WO 2012/069739

(56) Documents cités:
- DE-U1-202005 010 252
- US-A1- 2006 064 998
- US-A1- 2009 032 320
- US-B1- 6 327 128

## Description

La présente invention concerne d'une manière générale le domaine des machines électriques tournantes notamment pour véhicule automobile.

Elle s'applique plus particulièrement aux alternateurs à redressement synchrone équipé de modules électroniques de puissance, et encore plus particulièrement aux alternateurs polyphasés.

Pour fixer les idées, on se placera dans ce qui suit dans le cas de l'application préférée de l'invention et il sera supposé que l'alternateur est du type triphasé, sans que cela limite en quoi que ce soit la portée de l'invention.

A titre d'exemple, le brevet français FR2886477B1 intitulé "Pièce d'interconnexion de signal pour machine électrique tournante", décrit une machine électrique tournante de type alterno-démarreur comportant des moyens électroniques de puissance. Ces moyens électroniques de puissance se présentent sous la forme de modules de type dit mécatronique incluant un pont de transistors de puissance en technologie MOSFET et assurent une fonction réversible de convertisseur analogique-continu de puissance ("AC/DC" selon la terminologie anglo-saxonne couramment utilisée).

Dans le mode de fonctionnement en alternateur de la machine électrique tournante, le convertisseur précité assure le redressement des tensions alternatives de phase produites par l'alternateur en une tension continue unique d'alimentation (typiquement 14 Volts) qui alimente un réseau d'alimentation de bord du véhicule automobile. Inversement, comme il est bien connu de l'homme de métier, dans le mode de fonctionnement en moteur/démarreur de la machine électrique tournante, le convertisseur fournit des tensions de phase qui alimentent des bobinages statoriques de la machine électrique tournante. Une rotation du rotor de la machine électrique tournante dotée d'un couple mécanique suffisant est ainsi provoquée, ce de manière à assurer le démarrage du moteur thermique du véhicule. Les tensions de phase fournies sont obtenues par découpage, au moyen du pont de transistors de puissance, de la tension continue du réseau d'alimentation de bord (tension continue fournie par une batterie de stockage d'énergie).

Les moyens électroniques de puissance décrit dans le brevet français précité FR2886477B1 comportent trois modules identiques, un par branche de pont et un module de commande intégrant un circuit intégré spécialisé connu sous l'acronyme "ASIC" (pour "Application-Specific Integrated Circuit" selon la terminologie anglo-saxonne couramment utilisée) Les modules de branche de pont forment chacun une branche du pont de transistors.

L'architecture du module de branche de pont selon ce brevet est décrite, par exemple, par référence aux Fig.4A à 4E. Des transistors MOSFET, sous forme de puces électroniques nues, sont brasés sur des grilles de connexion, dites "leadframes" selon la terminologie anglo-saxonne couramment utilisée, qui sont surmoulées dans un boîtier mécatronique. Ces grilles de connexion sont maintenues plaquées sur une semelle métallique par l'intermédiaire d'une plaquette électriquement isolante qui est disposée en sandwich entre les grilles de connexion et la semelle. La plaquette possède des propriétés de bonne conduction thermique de manière à transmettre les calories générées par les puces électroniques vers un dissipateur thermique placé sous la semelle métallique du module.

La technologie divulguée par le brevet français FR2886477B1 trouve diverses applications dans les machines électriques tournantes et donne en particulier de très bons résultats, en termes de qualité et de performances, dans les applications de type alterno-démarreur qui nécessitent un pont de redressement réversible.

Cependant, comme il a été rappelé, il est nécessaire de conditionner les puces électroniques dans un boîtier en technologie dite mécatronique.

Ces dispositions augmentent la complexité, notamment celle de la structure d'interconnexion objet principal de ce brevet, et le nombre de pièces mécaniques utilisées, et de ce fait notamment le prix de revient.

Le document US 2009/0032320 A1 divulgue un convertisseur de puissance automobile.

L'invention, tout en conservant les avantages des dispositifs de l'Art Connu, notamment celles décrites dans le brevet français FR-28864 7781, vise à en pallier les inconvénients, dont certains viennent d'être rappelés.

L'invention, tout en proposant une architecture de modules électroniques de puissance interconnectés pour une machine électrique tournante polyphasée optimisée, se fixe pour but un procédé de réalisation d'une structure d'interconnexion de ces modules de puissance entre eux, d'une part, et de ces modules de puissance avec d'autres composants électriques de ladite machine électrique tournante.

Pour ce faire, selon une caractéristique importante de ladite architecture, les modules de puissances sont implémentés directement dans un dissipateur thermique, ce qui supprime, notamment, la nécessité de les encapsuler dans un boitier de type dit mécatronique et va permettre de simplifier les éléments de la structure d'interconnexion inter-modules.

Dans une forme de réalisation particulière, les modules de puissance comprennent chacun les circuits électroniques de puissance de deux branches de pont de redressement synchrone et des circuits de commande des circuits électroniques de puissance.

De façon préférentielle, les circuits de puissances sont réalisés à base de transistor MOSFET. Les circuits de commande sont réalisés de préférence en technologie dite "ASIC" (acronyme de l'expression anglo-saxonne couramment utilisée "Application Specific Integrated Circuits" ou circuits intégrés pour applications spécifiques). Les modules de puissance comprenant les circuits électroniques de puissance proprement dits et les circuits de commande présentent sous la forme de substrats en technologie dite "DBC" (acronyme de l'expression anglo-saxonne couramment utilisée "Direct Bonded Copper" ou cuivre directement collé) qui présente de nombreux avantages, notamment une bonne conductivité thermique. Le substrat est constitué de trois couches comprenant un couche inférieure en cuivre, une couche isolante médiane en céramique (alumine, oxyde de béryllium, etc.) et une couche supérieure en matériau conducteur, généralement du cuivre. Cette couche est subdivisée en une pluralité de traces conductrices, les composants électroniques du module de puissance étant brasés à ces traces. Cette technologie est bien connue de l'Homme de Métier et il est inutile de la détailler plus avant.

Selon une autre caractéristique de l'architecture de modules de puissance mise en oeuvre dans la présente invention, le dissipateur thermique comporte des cavités ouvertes sur une de ses faces destinées à recevoir chacune un desdits modules de puissance. Les modules de puissance sont collés directement sur le fond des cavités du dissipateur. De façon préférentielle, après assemblage, ces cavités sont remplies de gel de façon à recouvrir et isoler les modules de puissance.

Selon une caractéristique importante du procédé de réalisation de la structure d'interconnexion selon l'invention, les interconnexions entre les bornes des bobinages de phase de la machine tournante, les bornes de la source d'énergie électrique continue du véhicule (généralement une borne positive dite B+ et B- ou masse) et les bornes puissance des branches du pont redresseur et de signal des circuits de commande sont réalisées par l'intermédiaire, d'une part, de premiers moyens d'interconnexion comprenant une plaque en matériau isolant, par exemple du plastique, comportant une pluralité de traces conductrices, par exemple en cuivre, et, d'autre part, une pluralité d'éléments de connexion d'entrée-sortie avec les circuits électroniques des substrats précités. Les premiers moyens d'interconnexion seront dénommés ci-après connecteur plan, dans un but de simplification de la description.

Selon une autre caractéristique importante du procédé de l'invention encore, lesdits éléments de connexion sont réalisés simplement à base de composants filiformes en matériau conducteur de type languettes, clous, plots ou pins, et sont susceptibles de diverses configurations mécaniques et géométriques qui seront précisées ci-après.

Selon une autre caractéristique importante du procédé de l'invention encore, lesdits éléments de connexion sont brasés ou soudés par ultrasons directement sur les substrats et/ou sur les composants électroniques de puissance desdits modules de puissance, de manière à être inscrits dans des plans orthogonaux aux plans substrats précités disposés dans les cavités du dissipateur thermique.

Selon une autre caractéristique importante du procédé de l'invention encore, les connexions électriques entre, d'une part, les éléments de connexion d'entrée-sortie des circuits électroniques et, d'autre part, des traces conductrices du connecteur plan sont obtenues par une étape de soudure de type électrique par résistance ou laser par transparence.

Selon une autre caractéristique encore du procédé selon l'invention, le premier sous-ensemble constitué par les modules de puissance et le dissipateur thermique et le connecteur plan sont fixés mécaniquement l'un à l'autre après réalisation des étapes de connexions électriques par brasage ou soudure par ultrasons des éléments de connexion sur, d'une part, les substrats et/ou les composants de puissance, et, d'autre part, sur des traces conductrices du connecteur plan.

L'invention a donc pour objet principal un procédé d'interconnexion d'au moins deux modules électroniques de puissance d'une machine électrique tournante polyphasée, entre eux, et desdits modules de puissance avec des composants déterminés de ladite machine électrique tournante polyphasée, lesdits modules de puissance comprenant un substrat comprenant une couche constituée d'une première pluralité de traces conductrice sur laquelle sont implémentés des composants semi-conducteurs de puissance et des circuits intégrés électroniques de commande de ces composants reliés électriquement par lesdites traces conductrices, caractérisé en ce qu'il comprend une phase initiale comprenant une étape consistant à disposer lesdits substrats dans des cavités ouvertes sur une face dite supérieure d'un organe support de façon à être inscrits dans un premier plan de l'espace, une phase subséquente de réalisation desdites interconnexions comprenant au moins les étapes suivantes :
- une étape de réalisation de premiers moyens d'interconnexion constituant un connecteur plan comportant au moins une couche constituée d'une deuxième pluralité de traces conductrices portée par au moins une plaque, dite inférieure, en matériau isolant, de manière à former un réseau de liaisons électriques de configuration prédéterminée;
- une étape de réalisation d'une pluralité d'éléments de connexion dans chacun desdits modules de puissance constitués de composants filiformes en matériau conducteur, de conformations géométrique déterminée, et de leurs connexions électriques, par brasage ou soudure par ultrasons, en une première extrémité dite inférieure, aux dites traces conductrices des substrats et/ou aux dits composants électroniques de puissance, de manière à ce qu'ils soient inscrits dans des plans sensiblement orthogonaux au dit premier plan de l'espace;

- une étape de réalisation d'évidements dans au moins ladite plaque inférieure dudit connecteur plan, la distribution spatiale desdits évidements correspondant à la distribution spatiale desdits éléments de connexion
- une étape de placement dudit connecteur plan au-dessus desdits éléments de connexion, dans un plan parallèle au dit premier plan de l'espace, de manière à ce que les secondes extrémités, dites supérieures, desdits éléments de connexion puissent être mis en contact avec lesdites traces conductrices dudit connecteur au travers desdites ouvertures; et
- la réalisation de connexions électriques entre lesdites extrémités supérieures desdits éléments de connexion et lesdites traces conductrices par soudure.

L'invention a encore pour objet un assemblage de modules de puissance interconnectés obtenu par ce procédé.

L'invention va maintenant être décrite de façon plus détaillée en se référant aux dessins annexés, parmi lesquels :
- la figure 1 illustre schématiquement, en coupe longitudinale, un exemple de structure d'une machine électrique tournante selon l'Art Connu;
- la figure 2 illustre schématiquement un exemple de circuit de redressement de tension de type à redressement synchrone;
- la figure 3 illustre dans l'espace et en éclaté les principaux sous-ensembles d'un exemple d'architecture préférée de modules de puissances et de leurs interconnexions pour la mise en oeuvre du procédé d'interconnexion de modules de puissance selon l'invention :
- la figure 4 illustre schématiquement le montage des modules de puissance dans les cavités du dissipateur représenté sur la figure 3;
- la figure 4A est une vue de détail d'un élément de connexion représenté sur la figure 4;
- la figure 5 est une vue partielle du dissipateur et d'un module de puissance représentés sur la figure 4 illustrant un autre mode de réalisation des éléments de connexion; et
- les figures 6A à 6D illustrent quatre modes de réalisation selon l'invention d'éléments de connexion des modules de puissance à un connecteur d'interconnexion et les procédés de soudure mis en oeuvre dans ces modes de réalisation.

Dans ce qui suit, sans en limiter en quoi que ce soit la portée, on se placera ci-après dans le cadre de l'application préférée de l'invention, sauf mention contraire, c'est-à-dire dans le cas d'un alternateur à redressement synchrone du type double triphasé comprenant trois modules de puissance comportant chacun les circuits électroniques de puissance de deux branches de pont de redressement et des circuits de commande de ces circuits électroniques de puissance.

Toujours dans ce qui suit, les éléments identiques ou pour le moins similaires sur les figures portent les mêmes références et ne seront re-décrits qu'en tant que de besoin.

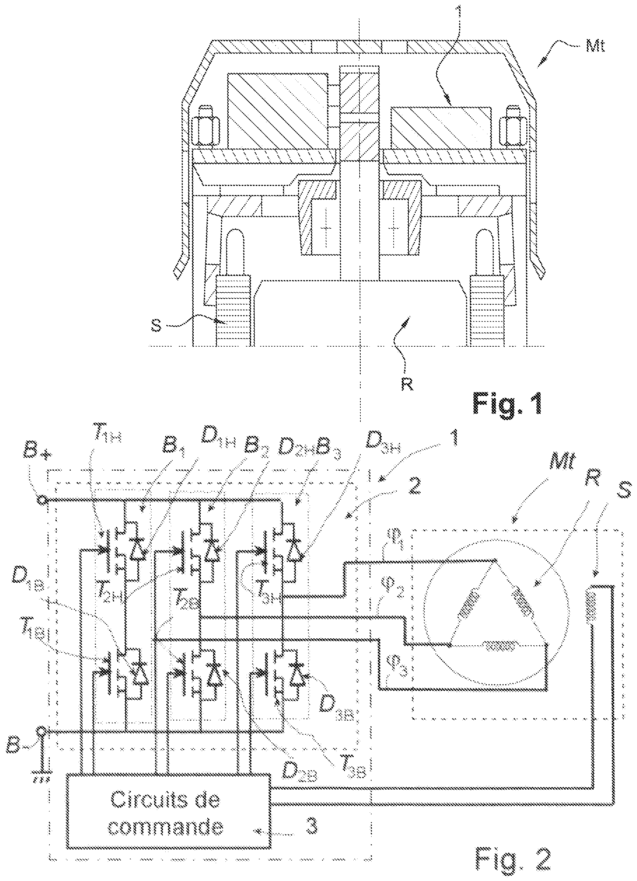

Avant de décrire l'invention, il est utile de rappeler brièvement la structure générale d'une machine de ce type et un exemple de circuits électroniques de puissance du pont de redressement et de circuit électronique de commande de ces circuits, par référence aux figures 1 et 2.

La figure 1 illustre très schématiquement, en coupe longitudinale, un exemple de structure d'une machine électrique tournante *Mt* selon l'Art Connu, à savoir ici, un alternateur triphasé à redressement synchrone. Celui-ci comprend, de manière classique, un stator *S* et un rotor *R,* ainsi qu'un module électronique de puissance, regroupant des circuits électroniques de puissance proprement dits (pont de redressement) et des circuits de commande de ces circuits de puissance.

La figure 2 illustre un exemple de configuration de circuits électriques et électroniques pouvant être mis en oeuvre dans l'alternateur triphasé *Mt* de la figure 1.

Comme illustré par la figure 2, l'alterno-démarreur *Mt* est associé à des circuits électroniques de puissance et de commande sous la référence générale 1. Ces circuits comprennent un pont synchrone de de redressement de tension 2 et un régulateur de tension 3. Le rotor R est entraîné en rotation par une courroie de transmission le reliant au vilebrequin du moteur thermique 5 du véhicule (non illustrés sur la figure 1).

Dans cette forme de réalisation, l'alternateur *Mt* est une machine triphasée de type Lundell.

La figure 2 illustre schématiquement un exemple de circuit de redressement de tension 2 de type à redressement synchrone. Celui-ci comprend essentiellement un pont de redressement de tension constitué de trois branches, *B*₁ à *B*₃, et des circuits de commande 3 du pont 2.

Dans l'exemple décrit, chaque branche, *B*₁ à *B*₃, du pont 2 comprend deux transistors de puissance en cascade de type MOSFET, *T*_{1H}-*T*_{1B}, *T*_{2H}-*T*_{2B}, *T*_{3H}-*T*_{3B}, respectivement. Les signes *H* et *B* signifient arbitrairement haut et bas de branche, respectivement. Les extrémités hautes des branches, *B*₁ à *B*₃, sont reliées à la borne *B*+ et les extrémités basses à la borne *B*- (généralement reliée à la masse) d'un organe de stockage d'énergie électrique continue (batterie du véhicule, non illustrée sur la figure 2). De façon classique en soi, des diodes antiparallèles, *D*_{1H} à D_{3B}, sont branchées aux bornes source et drain des transistors MOSFET, *T*_{1H} à *T*_{3B}.

Les branches *B*₁ à *B*₃, sont connectées en leurs points milieux aux trois sorties de phase, ϕ₁ à ϕ₃, des bobinages du stator S.

Les circuits de commande 3 délivrent aux grilles des transistors MOSFET, *T*_{1H} à *T*_{3B}, des signaux de commande, *CG*_{1H} à *CG*_{3B}, respectivement.

Les circuits de commande 2 comprennent des circuits de mise en forme des signaux de commande de grille (non explicitement illustrés sur la figure 2) qui réalisent une mise en forme adaptée des signaux, *CG*_{1H} à *CG*_{3B}, de manière à obtenir un fonctionnement en redressement synchrone des transistors MOSFET, *T*_{1H}-*T*_{1B}, du pont 2. Ce type de fonctionnement en redressement synchrone des transistors MOSFET, *T*_{1H}-*T*_{1B}, est bien connu de l'Homme de Métier et il est inutile de le décrire plus avant.

Les circuits de commande 2 comprennent également des circuits de régulation (non explicitement illustrés sur la figure 2), de façon à délivrer une tension continue de précision prédéterminée entre les bornes *B*+ et *B*-, classiquement +12 V. Ce type de circuits est également bien connu de l'Homme de Métier et il est inutile de le décrire plus avant.

De même, ces circuits de commande 3 délivrent un courant d'excitation de l'enroulement du stator *S*.

Enfin, les circuits de commande 3 peuvent comprendre des circuits de détection d'erreurs et/ou de dysfonctionnement du pont de redressement 2, notamment pour protéger les transistors MOSFET, T1H-T1B, en cas de détection de surcharge.

Dans l'Art Connu, notamment celui décrit par le brevet FR2886477B1, le pont 2 est, en réalité, divisé en trois parties correspondant aux trois branches de pont, *B*₁ à *B*₃. Chaque branche, B1 à B3, se présente sous la forme d'un substrat encapsulé dans un boîtier dit mécatronique indépendant et les circuits de commande sont réalisés sous la forme d'un circuit intégré "ASIC", l'ensemble étant complété par des moyens d'interconnexion électrique et de fixation mécanique. Comme il a été indiqué dans le préambule de l'invention, cette architecture présente un certain nombre d'inconvénients qu'il est inutile de rappeler ici.

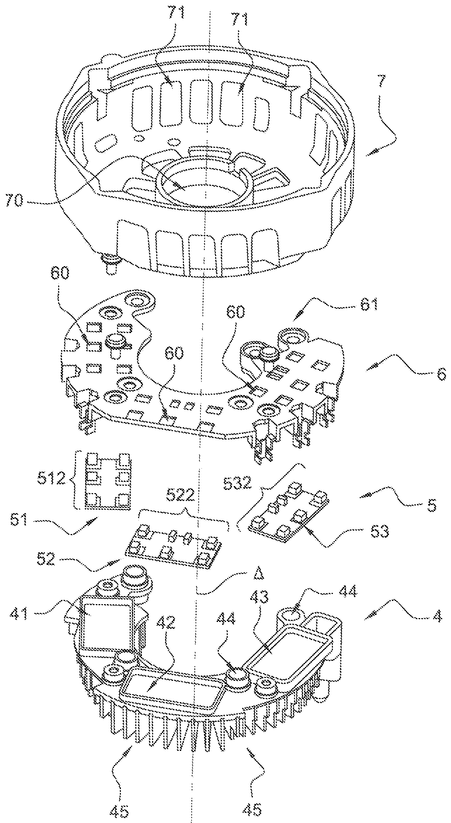

Dans la présente invention, tout en conservant la structure générale d'une machine tournante de l'Art Connu et la configuration des circuits électroniques en tant que telle, ce qui représente un avantage certain, on adopte une architecture de modules interconnectés optimisée qui ne nécessite plus un conditionnement de ceux-ci dans des boîtiers et permet une simplification des moyens de connexion. Pour ce faire, on prévoit une partition et une implémentation physique de ces circuits qui évitent les inconvénients précités et permet d'atteindre les buts visés, comme il va maintenant l'être montré en relation avec les figures 3 à 6D.

La figure 3 illustre dans l'espace et en éclaté autour d'un axe de symétrie longitudinal Δ, les principaux sous-ensembles d'un exemple d'architecture préférée de modules de puissance dans laquelle va être mis en oeuvre du procédé d'interconnexion selon l'invention.

L'architecture illustrée sur cette figure concerne un alternateur de type double triphasé et comprend trois sous-ensembles propres à l'invention : un dissipateur thermique 4, une série de modules de puissance 5, référencés 51 à 53, et des moyens 6 d'interconnexion électrique entre la série de modules 5. Les modules de puissance 5 de la série comporte chacun les circuits électroniques de deux branches de pont de redressement et les circuits de commande correspondants.

Selon une caractéristique importante de l'invention, le dissipateur thermique 4 est muni sur sa face supérieure (sur la figure 3), sensiblement plane, de trois cavités ouvertes, 41 à 43, à fond plat, destinées à recevoir les modules, 51 à 53. La face inférieure du dissipateur 4 est munie, de façon classique, d'ailettes 45 ou d'organes similaires destinées à améliorer les échanges thermiques avec l'air ambiant.

Le dissipateur thermique 4 a la forme générale d'un "fer à cheval" (arc de cercle) de façon à laisser un libre passage à l'air dans sa partie centrale, ce dans un but de refroidissement des organes internes de la machine tournante (bobinages, etc.), dont seule la partie mécanique supérieure 7 (palier arrière) a été représentée sur la figure 3. De façon habituelle, l'air ambiant est aspiré vers l'intérieur de la machine tournante par un ventilateur tournant avec le rotor (non représentés sur la figure 3). La pièce 7 comporte une pluralité d'orifices (non repérés) entourant un orifice central 70 destiné à recevoir une capsule de roulement, et des orifices latéraux 71 laissant entrer l'air à l'intérieur de la machine tournante.

De façon classique en soi, après assemblage final, les trois sous-ensembles, 4 à 6, sont assujettis mécaniquement à la pièce mécanique 7 par tous moyens appropriés (vis, etc.), le "fer à cheval" couvrant partiellement la périphérie.

Chaque module, 51 à 53, comprend un substrat regroupant des circuits électroniques de puissance proprement dits (les transistors MOSFET de deux branches du pont de redressement hexaphasé) et des circuits de commande de ce pont.

Selon une autre caractéristique de cette architecture, les circuits de commande sont répartis dans les trois modules, 51 à 53, et non pas centralisés comme pour l'exemple d'alternateur triphasé de la figure 2. Ils se présentent sous la forme de circuits intégrés réalisés préférentiellement en technologie "ASIC".

En dehors de ces particularités, les schémas fonctionnels des circuits de puissance et de commande mis en oeuvre dans l'art connu peuvent être conservés dans le cadre de l'invention, ce qui représente un avantage supplémentaire comme déjà signalé, puisqu'une nouvelle conception fonctionnelle de ces circuits n'est pas nécessaire.

Les circuits de puissance et de commande sont disposés sur un substrat, le tout réalisé préférentiellement en technologie "DBC" et constituant les modules de puissance précités, 51 à 53.

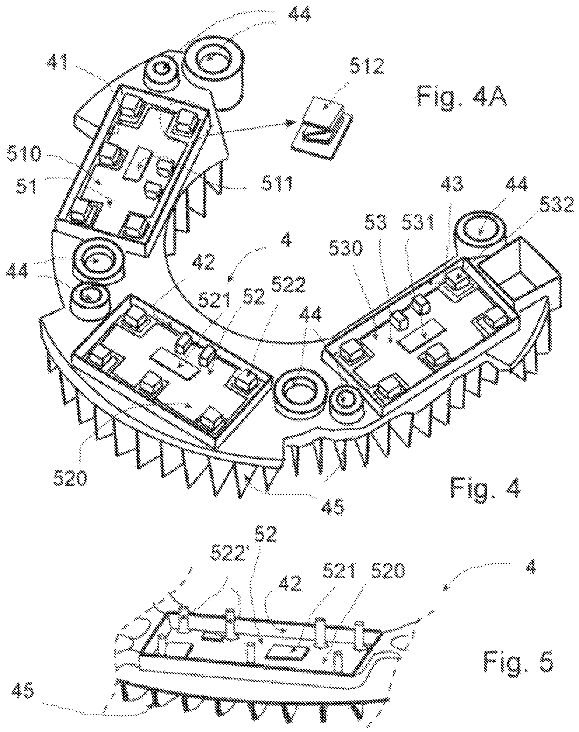

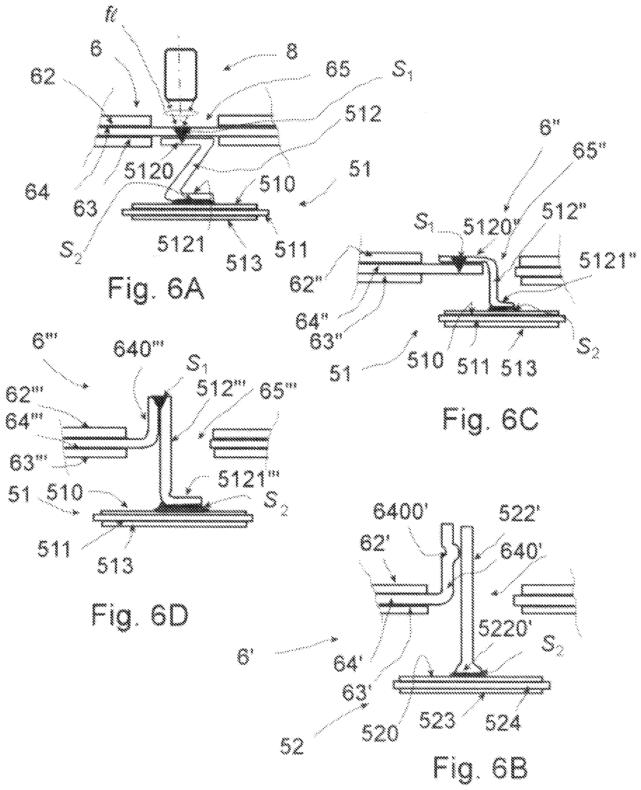

Les substrats des modules, 51 à 53, seront précisés ci-après par référence à la figure 4. Des éléments de connexion (figure 3 : sous les références générales 512, 522 et 532), susceptibles de prendre diverses configurations (qui seront décrites de façon détaillée par référence aux figures 6A à 6D), sont brasés ou soudés par ultrasons directement sur les substrats des modules, 51 à 53, conformément à une des caractéristiques importantes du procédé d'interconnexion de modules de puissance selon l'invention. Ils permettent d'établir des connexions électriques avec les moyens d'interconnexion 6 entre modules 5. Après brasage ou soudure par ultrasons, les éléments de connexion sont inscrits dans un plan substantiellement orthogonal aux substrats.

Les moyens d'interconnexion 6 se présentent sous la forme générale d'une platine constituant un connecteur électrique plan. Cette platine comprend une ou plusieurs couches planes en matériau isolant, par exemple du plastique de type PPS. Cette platine supporte une pluralité de pistes ou traces conductrices, par exemple en cuivre ou tout autre métal approprié, véhiculant, d'une part, des courants électriques dits "forts" (liaisons avec les bornes *B*+ et *B*- de la batterie, les bornes des branches du pont de redressement, réparties dans les modules, 51 à 53, et les bornes des bobinages de la machine tournante), et, d'autre part, courants dits "faibles" (signaux de commande). Les traces conductrices peuvent être surmoulées et disposées en sandwich entre des couches de matériau isolant de la platine 6.

Chaque élément de connexion précité, brasés sur les substrats des modules, 51 à 53, est connecté électriquement à une ou plusieurs traces conductrices de façon à former un réseau d'interconnexions de configuration prédéterminée reliant les modules, 51 à 53, entre eux et un régulateur de tension présent également dans l'alternateur, d'une part et, d'autre part, ces modules, 51 à 53, aux bornes de phases et de tension redressée de sortie (borne B+ et de masse) de l'alternateur. Pour ce faire, la platine 6 formant connecteur présente une géométrie semblable de celle du dissipateur thermique 4 (forme en "fer à cheval"), de façon à pouvoir la fixer mécaniquement sur celui-ci, après assemblage des modules, 51 à 53, dans les cavités, 41 à 43.

La platine 6 comporte en outre des zones, sous la référence générale 60, laissant libre accès aux traces conductrices dont les dimensions et la répartition spatiale sont en adéquation avec celles des éléments de connexion, 512, 522 et 532, brasés sur les substrats des modules, 51 à 53.

L'assujettissement mécanique des deux sous-ensembles : dissipateur thermique 4 et connecteur 6 s'effectue par tous moyens classique bien connu de l'Homme de Métier (vissage, etc.). Pour fixer les idées, sur la figure 3, on a représenté, de façon schématique, des moyens de fixation sous les références générales 44 (dissipateur thermique 4) et 61 (connecteur 6). En outre, comme déjà signalé, cet assemblage est aussi fixé mécaniquement à la pièce 7 par tous moyens conventionnels (non représentés sur la figure 3).

La figure 4 illustre schématiquement, en vue de haut dans l'espace, le montage des modules 51 à 53 dans les cavités 41 à 43 du dissipateur 4.

Les modules, 51 à 53, comprennent des substrats dont seules les couches supérieures ont été référencées, 510 à 530. Ces substrats sont préférentiellement réalisés en technologie "DBC". On a également représenté sur la figure 4 des circuits intégrés 511 à 531 portés par les substrats. Dans cette forme de réalisation de l'invention, un seul circuit de commande 511, 521 ou 531 est prévu par module, 51 à 530. Cependant, on doit bien comprendre que ceux-ci peuvent comprendre plusieurs circuits intégrés : notamment les circuits de commande de pont, préférentiellement réalisés en technologie "ASIC" et les transistors MOSFETS. Enfin, on a représenté schématiquement, des éléments de connexion. Ces éléments de connexion sont directement brasés sur plages conductrices et/ou sur les circuits intégrés des modules, 51 à 53, et sont destinés à établir des contacts galvaniques avec les traces conductrices du connecteur 6 (figure 3).

Les configurations géométriques et les modes de réalisation de ces éléments, qui constituent une des caractéristiques importantes de l'invention, seront précisés ci-après par référence aux figures 6A à 6D.

Un seul élément de connexion a été expressément référencé sur la figure 4 : l'élément de connexion 512 du module 51, illustré de façon plus détaillé par la figure 4A. L'élément 512 a la forme générale d'une languette en matériau conducteur repliée en "Z", ayant une face plane inférieure en contact électrique avec le substrat des modules, 51 à 53, et une face plane supérieure destinée à être mise en contact électrique avec une des traces du connecteur 6 (figure 3). Ce mode de réalisation correspond à celui qui sera explicité en regard de la figure 6A.

La figure 5 illustre un autre mode de réalisation d'éléments de connexion, sous la forme de plots cylindriques verticaux, du type queue de diode semi-conductrice ou de composants similaires (résistance, etc.). Sur la figure 5, seule la partie centrale du dissipateur thermique 4 a été représentée, c'est-à-dire celle correspondant à la cavité 42 et au module 52. A l'exception du mode de réalisation de l'élément de connexion 522', les autres éléments de la figure 5 sont identiques à ceux de la figure 4 et il est inutile de les re-décrire. Ce mode de réalisation d'élément de connexion correspond à celui qui sera explicité plus particulièrement en regard de la figure 6B, mais il peut être mis en oeuvre aussi pour ceux correspondant à ceux qui seront explicités en regard des figures 6C et 6D.

Quel que soit le mode de réalisation des éléments de connexion retenu, la fixation des modules, 51 à 53, dans les cavités, 41 à 43, est obtenu par collage sur le fond de ces cavités, directement sur le dissipateur 4, c'est-à-dire sans éléments intermédiaires contrairement à l'art connu décrit par le brevet français FR2886477B1. Pour fixer les idées, une colle du type colle thermique silicone peut être utilisée à cette fin. Après assemblage des modules, 51 à 53, dans les cavités, 41 à 43, ces dernières peuvent être remplies d'un gel tel par exemple qu'un gel silicone bi-composant, ce qui permet d'isoler électriquement les composants semi-conducteurs et de réaliser une protection mécanique.

Pour fixer les idées et sans que cela limite en quoi que ce soit la portée de l'invention, on va maintenant décrire, par référence aux figures 6A à 6D, quatre modes de réalisation principaux d'éléments de connexion, ainsi que les procédés de connexions correspondants de ces éléments de connexion aux traces conductrices du connecteur 6 (figure 3).

La figure 6A illustre schématiquement un élément de connexion 512 constitué d'une languette plate en matériau conducteur, pliée en accordéon pour prendre la forme générale d'un "Z". Ce mode de réalisation correspond à celui qui a été illustré par la figure 4.

On a représenté schématiquement sur la figure 6A le substrat du module 51 et on a supposé qu'il comprenait une plaque de matériau isolant 511, en sandwich entre une plaque sous-jacente de matériau conducteur 513 et des plages conductrices 510 courant sur la face supérieure. La configuration est identique pour les autres substrats, 52 ou 53

Chaque élément de connexion 512 est brasé (par la branche inférieure 5121 du "Z") sur une plage conductrice 510, ou à titre d'alternative sur un élément semi-conducteur (MOSFET du pont de redressement non représenté sur la figure 6A) : soudure *S*₂. La couche supérieure 510 est constituée d'une pluralité de traces d'interconnexions entre des bornes d'entrée et/ou sorties des composants du module de puissance (51 dans l'exemple de la figure 6A) soudés sur cette couche.

On a également représenté sur la figure 6A une portion du connecteur 6 disposé en surplomb du module 51 et de l'élément de connexion 512. On a supposé, dans l'exemple décrit, que le connecteur 6 comportait une seule couche 64 de traces en matériau conducteur, disposée en sandwich entre deux plaques de matériau isolant, supérieure 62 et inférieure 63. Naturellement, on doit bien comprendre que l'invention n'est pas limitée à une seule couche de traces conductrices. On peut en effet prévoir, dans une variante de réalisation non représentée, plusieurs couches de traces conductrices superposées séparées par des plaques de matériau isolant.

On prévoit des évidements 65 dans les zones des plaques isolantes, 62 et 63, surplombant les banches supérieures 5120 des éléments de connexion 512.

Selon ce mode de réalisation, de par leur forme en "Z" et les propriétés élastiques du matériau constituant la languette, les éléments de connexion 512 sont dotés d'une fonction "ressort", ce qui permet d'assurer un bon contact mécanique en exerçant une force d'appui lors de la mise en place du connecteur 6.

Les traces 64 du connecteur 6 sont soudées sur l'élément de connexion 512 (sur la branche supérieure 5120 du "Z") par soudure laser par transparence, c'est-à-dire au travers de la trace conductrice 64 : soudure *S*₁. Le laser 8 permettant cette opération est illustré schématiquement sur la figure 6A, ainsi que le faisceau émis *fl* convergeant sur la branche supérieure 5120 du "Z".

Une soudure laser présente l'avantage d'exiger moins d'énergie que la soudure par résistance. Il y a donc moins de risques d'endommager les brasures sur les substrats et les composants semi-conducteurs (MOSFETS).

Pour fixer les idées, les caractéristiques du procédé de réalisation des connexions électriques sont typiquement les suivantes :
- Idéalement, l'épaisseur de la trace 63 à traverser ne doit pas dépasser 0,6 mm;
- L'épaisseur de la trace située en dessous (c'est-à-dire la branche supérieure 5120 du "Z") doit être au moins égale à l'épaisseur de la trace traversée 64;
- Le jeu maximum admissible entre les traces, 64 et 5120, pour une soudure traversante est d'environ 20% de l'épaisseur traversée soit 0,12 mm dans l'exemple retenu;
- Un effort de pression sur le connecteur 6 est nécessaire et doit être calculé pour ne pas endommager le substrat 52 et ses composants;
- Pour obtenir une bonne soudure laser par transparence, la trace du dessus 64 doit subir un traitement de surface mat du type nickelage pour limiter la réflexion du faisceau laser (par exemple, en mettant en oeuvre la technologie de nickelage dite « sulfamat » - marque déposée). Par contre l'étain et le phosphore ne sont pas acceptables car ils risquent de créer des fissures dans la soudure.

La figure 6B illustre schématiquement un élément de connexion 522' constitué d'un plot cylindrique en matériau conducteur perpendiculaire au plan de la couche supérieure 520 du substrat 52 (ou des autres substrats, 51 ou 53). Le plot 522' comportent une embase 5220' de plus grand diamètre brasée directement (soudure *S*₂) sur la couche supérieure 520 du substrat sous-jacent 52 (ou en alternative sur un composant de puissance : MOSFET, non représenté). La couche supérieure 520 est constituée d'une pluralité de traces d'interconnexions entre des bornes d'entrée et/ou sorties des composants du module de puissance (52 dans l'exemple de la figure 6B) soudés sur cette couche. Ce mode de réalisation correspond à celui qui a été illustré par la figure 5.

Selon ce mode de réalisation et dans l'exemple décrit sur la figure 6B, le connecteur, désormais référencé 6', est supposé comporter, comme dans l'exemple de la figure 6A, une seule couche de traces conductrices 64', en sandwich entre deux plaques de matériau isolant, 62' et 63'. Par contre, toujours dans ce mode de réalisation, il est nécessaire que la trace conductrice 64', et non seulement les plaques isolantes, 62' et 63', soit également munie d'une alvéole, 65', pour laisser le libre passage à l'extrémité supérieure de l'élément de connexion 522' au travers de l'empilement de couches 62'-64'-63'. Une des extrémités, 640', de de la trace conductrice 64' se prolonge dans la zone d'évidement 65'. Elle est repliée à 90° vers le haut. Cette dernière comporte un embouti 6400' destinée à être mis en contact avec l'élément de connexion 522' dans sa partie supérieure.

Dans ce mode de réalisation, la soudure entre la trace 64' et l'élément de connexion est réalisé par un procédé de soudure par résistance au niveau de l'embouti 6400'. Il s'agit d'un procédé bien connu de l'Homme de Métier. Il est couramment utilisé, notamment utilisé pour souder des queues de diodes semi-conductrices ou des composants équivalents.

Pour fixer les idées, selon cette variante, les caractéristiques du procédé de réalisation des connexions électriques sont typiquement les suivantes :
- le procédé de soudure par résistance est bien maîtrisé et ne pose pas de problème particulier si les éléments à souder (plots 522' et trace 64') ont des dimensions semblables à celles de diodes semi-conductrices précitées;
- typiquement, les plots 522' ont un diamètre de 1,2 mm;
- en variante, au lieu d'être cylindriques, les plots 522' peuvent être dotés d'une section carrée ou rectangulaire si la languette repliée 640' de la trace 64' comporte un picot embouti;
- des paramètres typiques de la soudure sont les suivants : effort de 35 DaN, courant électrique d'environ 8000 A sous 2 V durant un lapse de temps de 20 à 30 ms. Les électrodes doivent descendre jusqu'à 1,5 mm minimum sous le bossage 6400' de la trace 64'.

La figure 6C illustre une variante supplémentaire de réalisation des éléments de connexion, désormais référencés 512".

Comme précédemment, l'élément de connexion 512" est constitué par un plot cylindrique en matériau conducteur, perpendiculaire au plan de la couche supérieure 510 du substrat 51 (ou des autres substrats, 52 ou 53). L'embase 5121" de celui-ci, qui peut être constituée d'un repli à 90°, est brasée (soudure *S*₂) sur la couche supérieure 510 du substrat sous-jacent 51 (ou en alternative sur un composant de puissance : MOSFET, non représenté sur la figure 6C).

On a supposé, comme précédemment que la trace conductrice 64" était unique et prise en sandwich entre deux plaques en matériau isolant, 62" et 63". Comme précédemment également, cette trace conductrice 64" est percée d'un orifice 65", se prolonge dans la zone d'évidement tout en laissant passer l'extrémité du plot 512". La partie supérieure 5120" de l'élément du plot 512" est repliée à 90°, de façon à venir en contact avec la face supérieure de l'extrémité de la trace conductrice 64".

Comme dans le mode de réalisation de connexion décrit en regard de la figure 6A, la soudure est du type soudure laser par transparence et en présente les avantages qui ont été rappelés. C'est donc la partie repliée 5120" du plot qui est traversé par le faisceau laser (non explicitement représentés sur la figure 6C) et soudée à la trace conductrice 64" : soudure *S*₁.

Pour fixer les idées, les caractéristiques du procédé de réalisation des connexions électriques sont typiquement les suivantes :
- La trace à traverser par le faisceau laser, c'est-à-dire la partie repliée 5120" du plot 512", peut être plus fine, avec une épaisseur qui peut descendre jusqu'à 0,3 mm ce qui permet;
- une énergie nécessaire pour souder plus faible;
- une épaisseur de trace conductrice 64" de 0,8 mm à 1 mm pour passer le courant;
- aucune nécessité de recourir à un nickelage des traces 64" du connecteur 6";
- le contact entre traces 64" et plots 512" est assuré simplement par l'opération de pliage.

La figure 6D illustre une variante supplémentaire de réalisation de l'élément de connexion, désormais référencé 512"'. Ce dernier est semblable à l'élément de connexion 512" quant à sa configuration spatiale, mais de section rectangulaire ou carrée, et non plié dans sa partie supérieure. Son embase 5121"', qui peut être repliée à l'horizontal, est brasée (soudure *S*₂) sur la couche supérieure 510 du substrat sous-jacent 51 (ou en alternative sur un composant de puissance : MOSFET, non représenté).

Comme précédemment, on a supposé que le connecteur 6"' ne comportait qu'une seule couche de traces conductrices 64"', en sandwich entre deux plaques isolantes, 62"' et 63"'.

Il est également nécessaire de prévoir une ouverture totale 65"' dans les plaques isolantes, 62"' et 63"', et dans la trace conductrice 64"', de façon à laisser passer l'extrémité supérieure du plot 512"', d'une part, et, d'autre part, une extrémité de trace 640"' repliée à 90° vers le haut et mise en contact avec l'extrémité supérieure du plot 64"'.

La soudure est également effectuée selon le procédé laser par transparence à l'aide d'un laser semblable à celui représenté sur la figure 6A. La disposition relative des deux éléments permet d'effectuer une soudure laser (soudure *S*₁) à bords relevés sur les extrémités respectives de la trace conductrice 64'" et du plot 512"'.

Pour fixer les idées, les caractéristiques du procédé de réalisation des connexions électriques selon cette variante sont typiquement les suivantes :
- Cette solution nécessite un outillage pour plaquer la trace conductrice 64"' contre le plot 512"' car le jeu maximum pour souder correctement ces éléments ne doit pas dépasser 5% des épaisseurs des éléments en contact;
- Le laser doit être équipé d'un système de recalage vision ou doit être monté sur l'outil de plaquage précité pour assurer une soudure correcte à la jonction de la trace conductrice 64"' et du plot 512"';
- Un nickelage est possible sur l'une ou l'autre des surfaces d'éléments à souder, voire sur les deux, mais n'est plus nécessaire;
- Pour une trace 64"' du connecteur 6 de 0,8 mm d'épaisseur, il est nécessaire que l'élément de connexion brasé 5121"' ait une épaisseur de 0,4 mm minimum et préférentiellement que son épaisseur soit identique à celle de la trace conductrice 64"' en son extrémité 640"'.

A la lecture de ce qui précède, on constate aisément que l'invention atteint bien les buts qu'elle s'est fixée, et qu'il est inutile de rappeler entièrement.

Toutefois, le procédé d'interconnexion de modules de puissance selon l'invention n'est pas limité aux seuls modes de réalisation explicitement décrits en regard des figures 3 à 6D. De même, l'assemblage de modules électroniques de puissance obtenue par le procédé d'interconnexion selon l'invention ne s'applique pas seulement à un alternateur à pont de redressement synchrone, qui en constitue l'application préférée, mais de façon plus générale, à toute machine électrique tournante polyphasée comportant au moins deux modules de puissance à interconnecter via des éléments de connexion dont l'une des extrémités est brasée ou soudée par ultrasons sur ces modules et l'autre soudée à une trace conductrice d'un connecteur comportant au moins une couche de traces conductrices portée par au moins une plaque isolante.

## Revendications

1. Procédé d'interconnexion d'au moins deux modules électroniques de puissance d'une machine électrique tournante polyphasée, entre eux, et desdits modules de puissance avec des composants déterminés de ladite machine électrique tournante polyphasée, lesdits modules de puissance comprenant un substrat comprenant une couche constituée d'une première pluralité de traces conductrices sur laquelle sont implémentés des composants semi-conducteurs de puissance et des circuits intégrés électroniques de commande de ces composants reliés électriquement par lesdites traces conductrices, **caractérisé en ce qu'**il comprend une phase initiale comprenant une étape consistant à disposer lesdits substrats (51 à 53) dans des cavités ouvertes (41 à 43) sur une face dite supérieure d'un organe support (4) de façon à être inscrits dans un premier plan de l'espace, une phase subséquente de réalisation desdites interconnexions comprenant au moins les étapes suivantes :
- une étape de réalisation de premiers moyens d'interconnexion constituant un connecteur plan (6) comportant au moins une couche constituée (64) d'une deuxième pluralité de traces conductrices portée par au moins une plaque (63), dite inférieure, en matériau isolant, de manière à former un réseau de liaisons électriques de configuration prédéterminée;
- une étape de réalisation d'une pluralité d'éléments de connexion (512) dans chacun desdits modules de puissance (51 à 53) constitués de composants filiformes en matériau conducteur, de conformations géométriques déterminées, et de leurs connexions électriques, par brasage ou soudure par ultrasons, en une première extrémité dite inférieure (5121), sur lesdites traces conductrices des substrats (51 à 53) et/ou sur lesdits composants électroniques de puissance, de manière à ce qu'ils soient inscrits dans des plans sensiblement orthogonaux au dit premier plan de l'espace;
- une étape de réalisation d'évidements (65) dans au moins ladite plaque inférieure (63) dudit connecteur plan (6), la distribution spatiale desdits évidements correspondant à la distribution spatiale desdits éléments de connexion (512);
- une étape de positionnement dudit connecteur plan (6) au-dessus desdits éléments de connexion (512), dans un plan parallèle au dit premier plan de l'espace, de manière à ce que les secondes extrémités, dites supérieures (5120), desdits éléments de connexion (512) puissent être mis en contact avec lesdites traces conductrices (64) dudit connecteur (6) au travers desdites ouvertures (65); et
- la réalisation de connexions électriques entre lesdites extrémités supérieures (5120) desdits éléments de connexion (512) et lesdites traces conductrices (64) par soudure.

2. Procédé selon la revendication 1, **caractérisée en ce que** l'étape de réalisation dudit connecteur plan (6) comprend l'assemblage en sandwich d'au moins une couche de traces conductrices (64) entre deux plaques en matériau isolant (62, 63), lesdites traces conductrices (64) comprenant des liaisons à forte puissance véhiculant des courants dits "forts" pour interconnecter entre eux lesdits composants semi-conducteurs de puissance et des éléments électriques déterminés (ϕ₁ à ϕ₃, *B*+, *B*-) de ladite machine tournante (*Mt*) et des liaisons à faible puissance véhiculant des signaux de commande pour interconnecter lesdits circuits intégrés électroniques de commande (3).

3. Procédé selon l'une des revendications 1 ou 2, **caractérisé en ce qu'**il comprend, avant la réalisation desdites connexions électriques par brasage ou soudure par ultrasons, une étape consistant à plier en accordéon lesdits composants filiformes en matériau conducteur pour leur imposer la conformation géométrique générale d'un "Z" et les doter d'un effet ressort lorsqu'ils sont soumis à une force de compression, **en ce que** les branches inférieures (5121) desdits "Z" sont brasées ou soudées par ultrasons (*S*₂) sur lesdites traces conductrices (510) des substrats (51) et/ou lesdits composants électroniques de puissance, **en ce que** l'étape de positionnement dudit connecteur plan (6) au-dessus desdits éléments de connexion (512) consiste à exercer une force d'appui sur ledit connecteur plan (6), de manière à obtenir un contact mécanique, par les faces inférieures desdites traces conductrices (64) et au travers desdits orifices (65), avec lesdites branches supérieures de "Z" (5120), par ledit effet ressort, et une étape de connexions électriques desdites traces conductrices (64) et desdites branches supérieures de "Z" (5120) par soudure laser par transparence (*S*₁) au travers de l'épaisseur desdites traces conductrices.

4. Procédé selon l'une des revendications 1 ou 2, **caractérisé en ce que** ladite étape de réalisation d'évidements consiste à effectuer des évidements (65") traversant chaque plaque (62", 63") en matériau isolant dudit connecteur (6") et ladite couche de traces conductrices (64"), les extrémités desdites traces conductrices se prolongeant dans lesdites zones d'évidement (65"), **en ce qu'**il comprend, avant la réalisation desdites connexions électriques par brasage ou soudure par ultrasons (*S*₂), une étape consistant à plier à 90° lesdites extrémités inférieures (5121") de ces dits composants filiformes (512"), une étape de brasage ou soudure par ultrasons (*S*₂) desdites extrémités inférieures (5121") sur lesdites traces conductrices (510) des substrats (51) et/ou sur lesdits composants électroniques de puissance, **en ce que**, pendant ladite étape de positionnement dudit connecteur plan (6"), lesdites extrémités supérieures (5120") des éléments de connexion (512") sont enfilées dans lesdits orifices (65") et rabattus à 90° sur les faces supérieures desdites extrémités de traces conductrices (64") dudit connecteur plan (6), de manière à obtenir un contact mécanique, et **en ce qu'**il comprend une étape de connexions électriques desdites traces conductrices (64") et desdites extrémités supérieures (5120") par soudure laser par transparence (*S*₁) au travers de l'épaisseur desdites extrémités (5120") des éléments de connexion (512").

5. Procédé selon l'une des revendications 1 ou 2, **caractérisé en ce que** ladite étape de réalisation d'évidements consiste à effectuer des évidements (65"') traversant chaque plaque (62"', 63"') en matériau isolant dudit connecteur (6"') et ladite couche de traces conductrices (64"'), les extrémités desdites traces conductrices (640"') se prolongeant dans lesdites zones d'évidement (65"'), **en ce qu'**il comprend un étape consistant à plier lesdites extrémités de traces conductrices (640"') à 90° vers la face supérieure dudit connecteur plan (6"'), **en ce qu'**il comprend, avant la réalisation desdites connexions électriques par brasage ou soudure par ultrasons (*S*₂), lesdits composants filiformes étant dotés d'une section rectangulaire, une étape consistant à plier à 90° lesdites extrémités inférieures (5121"') de ces dits composants filiformes (512"'), **en ce qu'**il comprend une étape de brasage ou soudure par ultrasons (*S*₂) desdites extrémités inférieures (5121"') sur lesdites traces conductrices (510) des substrats (51) et/ou sur lesdits composants électroniques de puissance, **en ce que**, pendant ladite étape de positionnement dudit connecteur plan (6"'), lesdites extrémités supérieures d'éléments de connexion (512"') sont enfilées dans lesdits orifices (65"') et plaquées contre lesdites extrémités (640"') de traces conductrices (64"') pliées à 90°, de manière à obtenir un contact mécanique, et **en ce qu'**il comprend une étape de connexions électriques desdites extrémités (640"') de traces conductrices (64"') et desdites extrémités supérieures d'éléments de connexion (512"') par soudure laser (*S*₁) dite à bords relevés de ces extrémités.

6. Procédé selon l'une des revendications 1 ou 2, **caractérisé en ce que** ladite étape de réalisation d'évidements consiste à effectuer des évidements (65') traversant chaque plaque (62', 63') en matériau isolant dudit connecteur (6') et ladite couche de traces conductrices (64'), les extrémités desdites traces conductrices (640') se prolongeant dans lesdites zones d'évidement (65'), **en ce qu'**il comprend une étape consistant à plier lesdites extrémités de traces conductrices (640') à 90° vers la face supérieure dudit connecteur plan (6') et à y réaliser des emboutis (6400'), **en ce qu'**il comprend une étape de brasage ou soudure par ultrasons (S₂) sur lesdites traces conductrices (520) des substrats (52) et/ou sur lesdits composants électroniques de puissance desdites extrémités inférieures de ces dits composants filiformes (522'), au niveau d'une embase (5220') desdites extrémités inférieures, **en ce que**, pendant ladite étape de positionnement dudit connecteur plan (6'), lesdites extrémités supérieures d'éléments de connexion (522') sont enfilées dans lesdits orifices (65') et plaquées contre lesdits emboutis (6400'), de manière à obtenir un contact mécanique, et **en ce qu'**il comprend une étape de connexions électriques desdits emboutis (6400') et desdites extrémités supérieures d'éléments de connexion (522') par soudure électrique par résistance.

7. Assemblage de modules de puissance interconnectés d'une machine électrique tournante polyphasée, **caractérisé en ce qu'**il est obtenu par le procédé selon l'une quelconque des revendications précédentes.

8. Assemblage selon la revendication 7, **caractérisé en ce que** lesdits modules de puissances comprennent des substrats sur lesquels sont implémentés des composants électroniques de puissance constituant les branches d'un pont de redressement synchrone et des circuits intégrés électroniques de commande de ces branches de pont de redressement synchrone.

9. Assemblage selon la revendication 8, **caractérisé en ce que** lesdits substrats sont réalisés selon la technologie dite "DBC" et sont constitués d'au moins d'une couche inférieure (513) en matériau conducteur, d'une couche intermédiaire (511) en matériau isolant et d'une couche supérieure (510) constituée d'une pluralité de traces en matériau conducteur sur lesquels sont brasés lesdits composants semi-conducteurs de puissance(*T*_{1H}-*T*_{1B}) et lesdits circuits intégrés électroniques de commande (3), et **en ce que** lesdits éléments de connexion (512 à 532) sont brasés ou soudés par ultrasons sur lesdites traces de la couche supérieure (510) et/ou sur lesdits composants semi-conducteurs de puissance.

10. Assemblage selon la revendication 8, **caractérisé en ce que** lesdits circuits intégrés électroniques de commande (3) sont réalisés sous la forme de circuits intégrés spécialisés selon la technologie dite "ASIC" implémentés sur lesdits substrats.

## Patentansprüche

1. Verfahren zur Verbindung von mindestens zwei elektronischen Leistungsmodulen einer mehrphasigen drehenden elektrischen Maschine miteinander, und der Leistungsmodule mit bestimmten Bauteilen der mehrphasigen drehenden elektrischen Maschine, wobei die Leistungsmodule ein Substrat enthalten, das eine aus einer ersten Vielzahl von Leiterbahnen bestehende Schicht enthält, auf der Leistungshalbleiterbauteile und elektronische integrierte Steuerschaltungen dieser Bauteile ausgeführt sind, die elektrisch durch die Leiterbahnen verbunden sind, **dadurch gekennzeichnet, dass** es eine Anfangsphase enthält, die einen Schritt enthält, der darin besteht, die Substrate (51 bis 53) in offenen Hohlräumen (41 bis 43) auf einer so genannten Oberseite eines Trägerorgans (4) so anzuordnen, dass sie in eine ersten Ebene des Raums eingeschrieben sind, wobei eine folgende Phase der Herstellung der Verbindungen mindestens die folgenden Schritte enthält:
- einen Schritt der Herstellung erster Verbindungseinrichtungen, die einen ebenen Verbinder (6) bilden, der mindestens eine aus einer zweiten Vielzahl von Leiterbahnen bestehende Schicht (64) aufweist, die von mindestens einer so genannten unteren Platte (63) aus Isoliermaterial getragen wird, um ein Netz von elektrischen Verbindungen vorbestimmter Konfiguration zu bilden;
- einen Schritt der Herstellung einer Vielzahl von Verbindungselementen (512) in jedem der Leistungsmodule (51 bis 53), die aus drahtförmigen Bauteilen aus leitendem Material bestimmter geometrischer Gestaltungen bestehen, und ihrer elektrischen Verbindungen, durch Löten oder Ultraschallschweißen, an einem ersten so genannten unteren Ende (5121) mit den Leiterbahnen der Substrate (51 bis 53) und/oder den elektronischen Leistungsbauteilen, damit sie in Ebenen im Wesentlichen lotrecht zur ersten Ebene des Raums eingeschrieben sind;
- einen Schritt der Herstellung von Aussparungen (65) in mindestens der unteren Platte (63) des ebenen Verbinders (6), wobei die räumliche Verteilung der Aussparungen der räumlichen Verteilung der Verbindungselemente (512) entspricht;
- einen Schritt der Positionierung des ebenen Verbinders (6) über den Verbindungselementen (512) in einer Ebene parallel zur ersten Ebene des Raums, damit die zweiten so genannten oberen Enden (5120) der Verbindungselemente (512) mit den Leiterbahnen (64) des Verbinders (6) durch die Öffnungen (65) hindurch in Kontakt gebracht werden können; und
- die Herstellung von elektrischen Verbindungen zwischen den oberen Enden (5120) der Verbindungselemente (512) und den Leiterbahnen (64) durch Schweißen.

2. Verfahren nach Anspruch 1, **dadurch gekennzeichnet, dass** der Schritt der Herstellung des ebenen Verbinders (6) die sandwichartige Montage mindestens einer Schicht von Leiterbahnen (64) zwischen zwei Platten aus Isoliermaterial (62, 63) enthält, wobei die Leiterbahnen (64) Verbindungen hoher Leistung, die so genannte "starke" Ströme transportieren, um die Leistungshalbleiterbauteile und bestimmte elektrische Elemente (ϕ₁ bis ϕ₃, B+, B-) der drehenden Maschine (Mt) miteinander zu verbinden, und Verbindungen geringer Leistung enthalten, die Steuersignale transportieren, um die elektronischen integrierten Steuerschaltungen (3) miteinander zu verbinden.

3. Verfahren nach einem der Ansprüche 1 oder 2, **dadurch gekennzeichnet, dass** es vor der Herstellung der elektrischen Verbindungen durch Löten oder Ultraschallschweißen einen Schritt, der darin besteht, die drahtförmigen Bauteile aus Leitermaterial zickzackförmig zu falten, um ihnen die allgemeine geometrische Gestaltung eines "Z" zu verleihen, und sie mit einer Federwirkung zu versehen, wenn sie eine Druckkraft ausgesetzt sind, dass die unteren Schenkel (5121) der "Z" auf die Leiterbahnen (510) der Substrate (51) und/oder die elektronischen Leistungsbauteile hartgelötet oder ultraschallgeschweißt werden (S₂), dass der Schritt der Positionierung des ebenen Verbinders (6) über den Verbindungselementen (512) darin besteht, eine Auflagekraft auf den ebenen Verbinder (6) auszuüben, um einen mechanischen Kontakt durch die Unterseiten der Leiterbahnen (64) und durch die Öffnungen (65) hindurch mit den oberen Schenkeln der "Z" (5120) durch die Federkraft zu erhalten, und einen Schritt elektrischer Verbindungen der Leiterbahnen (64) und der oberen Schenkel des "Z" (5120) durch Laserdurchstrahlschweißen (S₁) durch die Dicke der Leiterbahnen hindurch enthält.

4. Verfahren nach einem der Ansprüche 1 oder 2, **dadurch gekennzeichnet, dass** der Schritt der Herstellung von Aussparungen darin besteht, Aussparungen (65") auszuführen, die jede Platte (62", 63") aus Isoliermaterial des Verbinders (6") und die Schicht von Leiterbahnen (64") durchqueren, wobei die Enden der Leiterbahnen sich in die Aussparungszonen (65") verlängern, dass es vor der Herstellung der elektrischen Verbindungen durch Hartlöten oder Ultraschallschweißen (S₂) einen Schritt, der darin besteht, die unteren Enden (5121") dieser drahtförmigen Bauteile (512") um 90° umzubiegen, einen Schritt des Hartlötens oder Ultraschallschweißens (S₂) der unteren Enden (5121") auf die Leiterbahnen (510) der Substrate (51) und/oder auf die elektronischen Leistungsbauteile enthält, dass während des Schritts der Positionierung des ebenen Verbinders (6") die oberen Enden (5120") der Verbindungselemente (512") in die Öffnungen (65") eingefädelt und um 90° auf die Oberseiten der Enden von Leiterbahnen (64") des ebenen Verbinders (6) umgeschlagen werden, um einen mechanischen Kontakt zu erhalten, und dass es einen Schritt elektrischer Verbindungen der Leiterbahnen (64") und der oberen Enden (5120") durch Laserdurchstrahlschweißen (S₁) durch die Dicke der Enden (5120") der Verbindungselemente (512") hindurch enthält.

5. Verfahren nach einem der Ansprüche 1 oder 2, **dadurch gekennzeichnet, dass** der Schritt der Herstellung von Aussparungen darin besteht, Aussparungen (65"') auszuführen, die jede Platte (62"', 63"') aus Isoliermaterial des Verbinders (6"') und die Schicht von Leiterbahnen (64"') durchqueren, wobei die Enden der Leiterbahnen (640"') sich in die Aussparungszonen (65"') verlängern, dass es einen Schritt enthält, der darin besteht, die Enden von Leiterbahnen (640"') um 90° zur Oberseite des ebenen Verbinders (6"') umzubiegen, dass es vor der Herstellung der elektrischen Verbindungen durch Hartlöten oder Ultraschallschweißen (S₂), wobei die drahtförmigen Bauteile mit einem rechtwinkligen Querschnitt versehen sind, einen Schritt enthält, der darin besteht, die unteren Enden (5121"') dieser drahtförmigen Bauteile (512"') um 90° umzubiegen, dass es einen Schritt des Hartlötens oder Ultraschallschweißens (S₂) der unteren Enden (5121"') auf die Leiterbahnen (510) der Substrate (51) und/oder auf die elektronischen Leistungsbauteile enthält, dass während des Schritts der Positionierung des ebenen Verbinders (6"') die oberen Enden von Verbindungselementen (512"') in die Öffnungen (65"') eingefädelt und gegen die um 90° umgebogenen Enden (640"') von Leiterbahnen (64"') gepresst werden, um einen mechanischen Kontakt zu erhalten, und dass es einen Schritt elektrischer Verbindungen der Enden (640"') von Leiterbahnen (64"') und der oberen Enden von Verbindungselementen (512"') durch so genanntes Bördelnaht-Laserschweißen (S₁) dieser Enden enthält.

6. Verfahren nach einem der Ansprüche 1 oder 2, **dadurch gekennzeichnet, dass** der Schritt der Herstellung von Aussparungen darin besteht, Aussparungen (65') auszuführen, die jede Platte (62', 63') aus Isoliermaterial des Verbinders (6') und die Schicht von Leiterbahnen (64') durchqueren, wobei die Enden der Leiterbahnen (640') sich in die Aussparungszonen (65') verlängern, dass es einen Schritt enthält, der darin besteht, die Enden von Leiterbahnen (640') um 90° zur Oberseite des ebenen Verbinders (6') umzubiegen und dort Ausbauchungen (6400') herzustellen, dass es einen Schritt des Hartlötens oder Ultraschallschweißens (S₂) auf die Leiterbahnen (520) der Substrate (52) und/oder auf die elektronischen Leistungsbauteile der unteren Enden dieser drahtförmigen Bauteile (522') im Bereich eines Sockels (5220') der unteren Enden enthält, dass während des Schritts der Positionierung des ebenen Verbinders (6') die oberen Enden von Verbindungselementen (522') in die Öffnungen (65') eingefädelt und gegen die Ausbauchungen (6400') gepresst werden, um einen mechanischen Kontakt zu erhalten, und dass es einen Schritt elektrischer Verbindungen der Ausbauchungen (6400') und der oberen Enden von Verbindungselementen (522') durch elektrisches Widerstandsschweißen enthält.

7. Montage von miteinander verbundenen Leistungsmodulen einer mehrphasigen drehenden elektrischen Maschine, **dadurch gekennzeichnet, dass** sie durch das Verfahren nach einem der vorhergehenden Ansprüche erhalten wird.

8. Zusammenbau nach Anspruch 7, **dadurch gekennzeichnet, dass** die Leistungsmodule Substrate enthalten, auf denen elektronische Leistungsbauteile, die die Schenkel einer synchronen Gleichrichterbrücke bilden, und elektronische integrierte Steuerschaltungen dieser synchronen Gleichrichterbrückenschenkel ausgeführt sind.

9. Montage nach Anspruch 8, **dadurch gekennzeichnet, dass** die Substrate gemäß der so genannten "DBC"-Technologie hergestellt werden und aus mindestens einer unteren Schicht (513) aus Isoliermaterial, einer Zwischenschicht (511) aus Isoliermaterial und einer oberen Schicht (510) bestehen, die aus einer Vielzahl von Bahnen aus leitendem Material besteht, auf die die Leistungshalbleiterbauteile (T_{1H}-T_{1B}) und die elektronischen integrierten Steuerschaltungen (3) hartgelötet sind, und dass die Verbindungselemente (512 bis 532) auf die Bahnen der oberen Schicht (510) und/oder auf die Leistungshalbleiterbauteile hartgelötet oder ultraschallgeschweißt werden.

10. Montage nach Anspruch 8, **dadurch gekennzeichnet, dass** die elektronischen integrierten Steuerschaltungen (3) in Form von besonderen integrierten Schaltungen gemäß der so genannten "ASIC"-Technologie hergestellt werden, die auf den Substraten ausgeführt werden.

## Claims

1. Method for interconnecting at least two electronic power modules of a polyphase rotary electric machine together, and for interconnecting said power modules with determined components of said polyphase rotary electric machine, said power modules comprising a substrate comprising a layer composed of a first plurality of conductive tracks on which power semiconductor components and integrated electronic control circuits for controlling these components that are electrically connected by said conductive tracks are implemented, **characterized in that** it comprises an initial phase comprising a step consisting of depositing said substrates (51 to 53) in open cavities (41 to 43) on a face referred to as the upper face of a carrier member (4) so as to be inscribed in a first plane in space, a subsequent phase of producing said interconnections comprising at least the following steps:
- a step of producing first interconnection means forming a planar connector (6) comprising at least one layer composed (64) of a second plurality of conductive tracks borne by at least one wafer (63), referred to as the lower wafer, made of an insulating material, so as to form a network of electrical connections of predetermined configuration;
- a step of producing a plurality of connecting elements (512) in each of said power modules (51 to 53) composed of filiform components made of a conductive material, of determined geometric conformations, and their electrical connections, through ultrasonic welding or soldering, on a first end referred to as the lower end (5121), to said conductive tracks of the substrates (51 to 53) and/or to said power electronic components, so that they are inscribed in planes that are substantially orthogonal to said first plane in space;
- a step of producing recesses (65) in at least said lower wafer (63) of said planar connector (6), the spatial distribution of said recesses corresponding to the spatial distribution of said connecting elements (512);
- a step of positioning said planar connector (6) on top of said connecting elements (512), in a plane that is parallel to said first plane in space, so that the second ends, referred to as the upper ends (5120), of said connecting elements (512) may be brought into contact with said conductive tracks (64) of said connector (6) through said openings (65); and
- producing electrical connections between said upper ends (5120) of said connecting elements (512) and said conductive tracks (64) through welding.

2. Method according to Claim 1, **characterized in that** the step of producing said planar connector (6) comprises sandwiching at least one layer of conductive tracks (64) between two wafers made of an insulating material (62, 63), said conductive tracks (64) comprising high-power connections conveying currents referred to as "high" currents in order to interconnect said power semiconductor components and determined electrical elements (ϕ₁ to ϕ₃, *B*+, *B*-) of said rotary machine (*Mt*) together, and low-power connections conveying control signals in order to interconnect said integrated electronic control circuits (3).

3. Method according to either of Claims 1 and 2, **characterized in that** it comprises, before producing said electrical connections through ultrasonic welding or soldering, a step consisting of folding said filiform components made of a conductive material like an accordion in order to confer upon them the general geometric conformation of a "Z" and to endow them with a spring effect when they are subjected to a compressive force, **in that** the lower arms (5121) of said "Z" are ultrasonically welded or soldered (*S*₂) to said conductive tracks (510) of the substrates (51) and/or said power electronic components, **in that** the step of positioning said planar connector (6) on top of said connecting elements (512) consists of exerting a pressing force on said planar connector (6) so as to obtain mechanical contact of the lower faces of said conductive tracks (64), through said orifices (65), with said upper arms of the "Z" (5120) via said spring effect, and a step of electrically connecting said conductive tracks (64) and said upper arms of the "Z" (5120) through laser transmission welding (*S*₁) through the thickness of said conductive tracks.

4. Method according to either of Claims 1 and 2, **characterized in that** said step of producing recesses consists of making recesses (65") passing through each wafer (62", 63") made of an insulating material of said connector (6") and said layer of conductive tracks (64"), the ends of said conductive tracks extending into said recessed areas (65"), **in that** it comprises, before producing said electrical connections through ultrasonic welding or soldering (*S*₂), a step consisting of folding said lower ends (5121") of these said filiform components (512") by 90°, a step of ultrasonically welding or soldering (*S*₂) said lower ends (5121") to said conductive tracks (510) of the substrates (51) and/or to said power electronic components, **in that**, in said step of positioning said planar connector (6"), said upper ends (5120") of the connecting elements (512") are threaded into said orifices (65") and folded back by 90° over the upper faces of said ends of the conductive tracks (64") of said planar connector (6) so as to obtain mechanical contact, and **in that** it comprises a step of electrically connecting said conductive tracks (64") and said upper ends (5120") through laser transmission welding (*S*₁) through the thickness of said ends (5120") of the connecting elements (512").

5. Method according to either of Claims 1 and 2, **characterized in that** said step of producing recesses consists of making recesses (65"') passing through each wafer (62"', 63"') made of an insulating material of said connector (6"') and said layer of conductive tracks (64"'), the ends of said conductive tracks (640"') extending into said recessed areas (65"'), **in that** it comprises a step consisting of folding said ends of the conductive tracks (640"') by 90° towards the upper face of said planar connector (6"'), **in that** it comprises, before producing said electrical connections through ultrasonic welding or soldering (*S*₂), said filiform components being endowed with a rectangular cross section, a step consisting of folding said lower ends (5121"') of these said filiform components (512"') by 90°, **in that** it comprises a step of ultrasonically welding or soldering (*S*₂) said lower ends (5121"') to said conductive tracks (510) of the substrates (51) and/or to said power electronic components, **in that**, in said step of positioning said planar connector (6"'), said upper ends of the connecting elements (512"') are threaded into said orifices (65"') and pressed against said ends (640"') of the conductive tracks (64"') that are folded by 90° so as to obtain mechanical contact, and **in that** it comprises a step of electrically connecting said ends (640'") of the conductive tracks (644"') and said upper ends of the connecting elements (512"') through laser welding (*S*₁) referred to as raised-edge welding of these ends.

6. Method according to either of Claims 1 and 2, **characterized in that** said step of producing recesses consists of making recesses (65') passing through each wafer (62', 63') made of an insulating material of said connector (6') and said layer of conductive tracks (64'), the ends of said conductive tracks (640') extending into said recessed areas (65'), **in that** it comprises a step consisting of folding said ends of the conductive tracks (640') by 90° towards the upper face of said planar connector (6') and of forming stamped parts there (6400'), **in that** it comprises a step of ultrasonically welding or soldering (*S*₂), at a base (5220') of said lower ends, said lower ends of these said filiform components (522') to said conductive tracks (520) of the substrates (52) and/or to said power electronic components, **in that**, in said step of positioning said planar connector (6'), said upper ends of the connecting elements (522') are threaded into said orifices (65') and pressed against said stamped parts (6400') so as to obtain mechanical contact, and **in that** it comprises a step of electrically connecting said stamped parts (6400') and said upper ends of the connecting elements (522') through electric resistance welding.

7. Assembly of interconnected power modules of a polyphase rotary electric machine, **characterized in that** it is obtained using the method according to any one of the preceding claims.

8. Assembly according to Claim 7, **characterized in that** said power modules comprise substrates on which power electronic components forming the arms of a synchronous bridge rectifier and integrated electronic control circuits for controlling these arms of the synchronous bridge rectifier are implemented.

9. Assembly according to Claim 8, **characterized in that** said substrates are produced using the technology referred to as "DBC" technology and are composed of at least one lower layer (513) made of a conductive material, one intermediate layer (511) made of an insulating material and one upper layer (510) composed of a plurality of tracks made of a conductive material to which said power semiconductor components (*T*_{1H}-*T*_{1B}) and said integrated electronic control circuits (3) are soldered, and **in that** said connecting elements (512 to 532) are ultrasonically welded or soldered to said tracks of the upper layer (510) and/or to said power semiconductor components.

10. Assembly according to Claim 8, **characterized in that** said integrated electronic control circuits (3) are produced in the form of specialized integrated circuits using the technology referred to as "ASIC" technology, which are implemented on said substrates.
